**Europäisches Patentamt**

**European Patent Office**

**Office européen des brevets**

(11) Numéro de publication : **0 506 527 B1**

(12) **FASCICULE DE BREVET EUROPEEN**

(45) Date de publication du fascicule du brevet :
**12.07.95 Bulletin 95/28**

(51) Int. Cl.<sup>6</sup> : **G01R 29/10, H01Q 3/26, G01S 7/40**

(21) Numéro de dépôt : **92400752.9**

(22) Date de dépôt : **20.03.92**

(54) **Procédé et dispositif de test d'une antenne multisources en fonctionnement.**

(30) Priorité : **26.03.91 FR 9103623**

(43) Date de publication de la demande :
**30.09.92 Bulletin 92/40**

(45) Mention de la délivrance du brevet :
**12.07.95 Bulletin 95/28**

(84) Etats contractants désignés :
**BE CH DE ES FR GB GR IT LI SE**

(56) Documents cités :
**EP-A- 0 053 512
US-A- 4 639 732
IEEE TRANSACTIONS ON ANTENNAS AND
PROPAGATION, vol. AP-33, no. 12, décembre1985, pages 1313-1327, New York, US; J.
RONEN et al.: "Monitoring techniquesfor phased-array antennas"
IEEE TRANSACTIONS ON ANTENNAS AND
PROPAGATION, vol. 36, no. 6, juin 1988, pages**

(56) Documents cités :
**884-889, New York, US; J.J. LEE et al.:
"Near-field probe used as a diagnostictool to
locate defective elements in an array antenna"
PATENT ABSTRACTS OF JAPAN, vol. 6, no.
198 (P-147)[1076], 7 octobre 1982; & JP-A-57
108 772 (MITSUBISHI) 06-07-1982
RADAR '87, INTERNATIONAL CONFERENCE,
19-21 octobre 1987, pages 185-188; A.JANEX:
"3D monopulse localization in airbourne IFF
interrogator"**

(73) Titulaire : **THOMSON-CSF
173, Boulevard Haussmann
F-75008 Paris (FR)**

(72) Inventeur : **Skrzypczak, Jean-Michel
THOMSON-CSF,
SCPI,
Cédex 67
F-92045 Paris la Défense (FR)**

(74) Mandataire : **Benoit, Monique et al
THOMSON-CSF
SCPI
B.P. 329
50, rue Jean-Pierre Timbaud
F-92402 Courbevoie Cédex (FR)**

## Description

La présente invention concerne un procédé et un dispositif de test on line, c'est-à-dire en fonctionnement d'une antenne composée d'une pluralité de sources rayonnantes.

Un domaine particulier d'application de l'invention concerne les antennes de radars secondaires de type monopulse, permettant de rayonner dans l'espace les impulsions produites par un interrogateur IFF (Identification friend or foe, c'est-à-dire identification ami-ennemi) et de capter les réponses éventuelles des avions interrogés. De telles antennes sont constituées d'une pluralité d'éléments rayonnants, appelés colonnes. Sur site, il est très difficile d'identifier si une ou plusieurs de ces colonnes sont en panne, et, dans le cas d'une baisse de performance de l'antenne, on ne sait pas localiser précisément la ou les colonnes qui en sont la cause.

Une méthode pratique connue de localisation des colonnes en panne consiste à placer un détecteur successivement devant chaque colonne pour vérifier si leur rayonnement est bien celui escompté. L'inconvénient d'une telle méthode réside dans l'interaction des diagrammes de rayonnements des colonnes avoisinant la colonne testée, ce qui rend peu précises les mesures effectuées. De plus, cette méthode nécessite l'arrêt temporaire de l'antenne dans ses fonctions d'interrogation et de réception de réponses des avions.

Il existe également différentes méthodes travaillant directement sur le diagramme de rayonnement de l'antenne et fondées sur les principes suivants :

- le niveau moyen des lobes secondaires peut permettre de détecter une panne. En fait, cette méthode est écartée car elle ne permet pas d'extraire une information fiable concernant les colonnes d'extrémités pour lesquelles les variations du niveau moyen sur les lobes secondaires sont trop faibles ;
- la fonction caractéristique de l'alignement des dipôles s'annule autant de fois qu'il y a d'éléments rayonnants dans l'alignement. L'observation du nombre de zéros devrait donc permettre la détection de pannes. Cependant, c'est une méthode peu fiable en ce sens qu'en pratique, des réflexions sur obstacles peuvent faire disparaître des zéros ;
- le diagramme de rayonnement d'une antenne se déduit de la Transformée de Fourier de l'éclairement de cette antenne. En calculant la Transformée de Fourier inverse, on devrait donc pouvoir reconstituer l'aspect de l'éclairement de l'antenne, et détecter ainsi des trous à l'endroit des colonnes en panne. En fait, cette méthode n'est pas exploitable car on ne peut pas récupérer l'information essentielle du signal, à savoir sa phase.

La Transformée de Fourier inverse est p. ex. utilisée dans le document IEE TRANSACTIONS ON ANTENNAS AND PROPAGATION, vol. 36, n°6, juin 1988, pages 884-889, New York, US, J.J. LEE et al. : "Near-Field Probe Used as a Diagnostic Tool to Locate Defective Elements in an Array Antenna".

L'objet de l'invention est de pallier les inconvénients précédents en proposant un procédé et un dispositif de test sur site du fonctionnement d'une antenne multi-sources qui permettent de localiser précisément la ou les sources rayonnantes qui sont en panne, sans que la fonction première de cette antenne soit gênée.

Bien que la description du procédé et du dispositif selon l'invention soit faite dans le cadre de l'application à une antenne de radar secondaire, il est d'ores et déjà important de noter que l'invention ne se limite pas à cette application particulière, comme nous le verrons par la suite.

L'invention a plus précisément pour objet un procédé de test sur site d'une antenne comportant une pluralité de sources rayonnantes, caractérisé en ce qu'il consiste à :

- constituer une bibliothèque de diagrammes de rayonnement de l'antenne d'une part, lorsque toutes les sources rayonnantes fonctionnent normalement et d'autre part, lorsqu'au moins l'une desdites sources est mise volontairement en panne ;
- relever le diagramme de rayonnement de l'antenne lors de son fonctionnement sur site ;
- calculer le coefficient de corrélation dudit diagramme de rayonnement avec chacun des diagrammes de rayonnement contenus dans ladite bibliothèque ;
- calculer la valeur maximale du coefficient de corrélation, de façon à détecter une panne éventuelle d'une ou de plusieurs desdites sources rayonnantes.

L'invention concerne également un dispositif de test sur site d'une antenne comportant une pluralité de sources rayonnantes, caractérisé en ce qu'il comporte :

- des premiers moyens de mesures et de mémorisation dans une bibliothèque des diagrammes de rayonnement de l'antenne d'une part, lorsque toutes les sources rayonnantes fonctionnent, et d'autre part, lorsqu'au moins l'une desdites sources est mise volontairement en panne ;
- des seconds moyens de mesure du diagramme de rayonnement de l'antenne lors de son fonctionnement sur site ;
- des moyens de calcul du coefficient de corrélation du diagramme de rayonnement de l'antenne et de chaque diagramme contenu dans ladite bibliothèque ;
- des moyens de calcul de la valeur maximale du coefficient de corrélation pour détecter une panne éventuelle.

Le procédé et le dispositif de test seront mieux compris lors de la description qui suit, relative aux figures suivantes :

- la figure 1 est une représentation de la face avant d'une antenne de radar secondaire ;
- la figure 2 est une représentation de la face arrière de cette même antenne ;
- la figure 3 représente les trois diagrammes de rayonnement de l'antenne précédente ;
- la figure 4 est une structure de blocs représentative des étapes à effectuer pour le test selon l'invention.

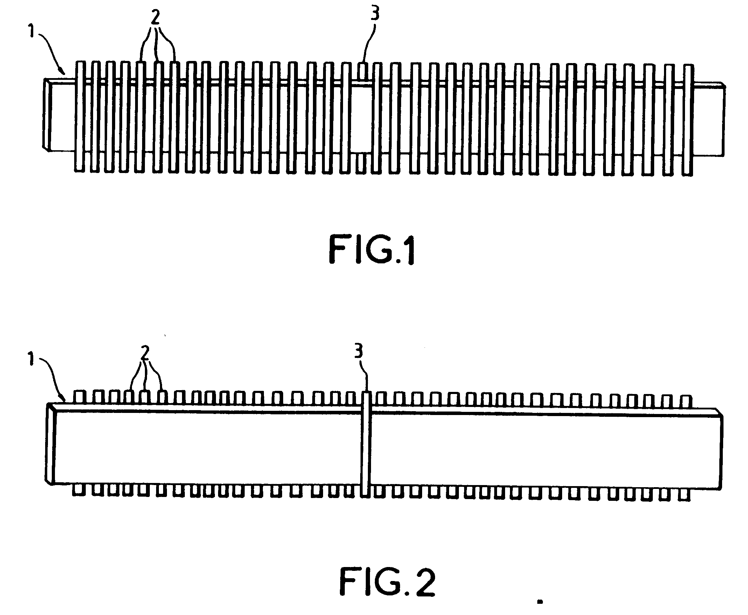

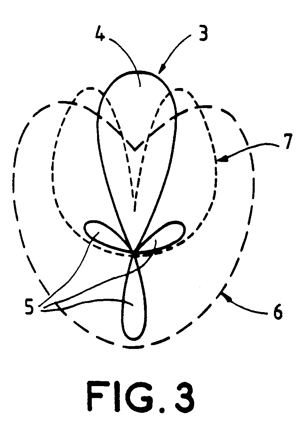

Les figures 1 et 2 représentent respectivement la face avant et la face arrière d'une antenne de radar secondaire de type monopulse. Cette antenne comporte une poutre 1 sur laquelle sont fixées des colonnes rayonnantes (2, 3), par exemple au nombre de trente six, les trente cinq colonnes 2 étant placées sur l'avant de l'antenne, et la colonne 3 étant placée à l'arrière. Le rayonnement peut être obtenu par exemple par une pluralité de dipôles rayonnants placés sur chaque colonne. L'antenne est destinée d'une part, à rayonner dans l'espace les signaux élaborés par un interrogateur (non représenté) et d'autre part, à capter les réponses émanant des transpondeurs montés sur les avions. Dans ce but, elle possède trois diagrammes de rayonnement schématisés sur la figure 3, obtenus par des répartitions différentes, en amplitude et en phase, de l'énergie entre les trente six colonnes rayonnantes. L'antenne rayonne tout d'abord un diagramme ($\Sigma$) 3 présentant un lobe principal directif 4 entouré de lobes secondaires 5, grâce auquel elle émet une paire d'impulsions d'interrogation. Pour éviter qu'un transpondeur à bord d'un avion proche réponde aux impulsions émises par les lobes secondaires 5, une troisième impulsion intercalée aux précédentes est émise selon le diagramme de rayonement ($\Omega$) quasi omnidirectionnel 6, lequel recouvre complètement les lobes secondaires 5. Ainsi, seuls les avions situés dans la zone de couverture du lobe principal 4 sont amenés à répondre aux interrogations de l'antenne. Le dernier diagramme 7, ou diagramme ($\Delta$), permet d'affiner la position de l'avion qui émet une réponse.

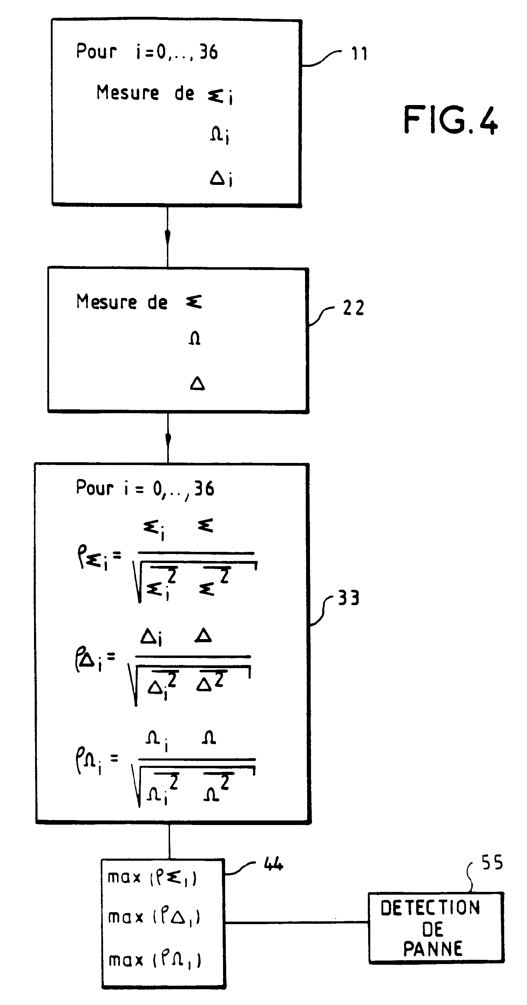

La figure 4 explicite les différentes étapes du procédé selon l'invention.

Une première étape référencée 11 consiste à mettre en mémoire dans une bibliothèque les trois diagrammes $\Sigma_i$, $\Omega_i$ et $\Delta_i$ mesurés par exemple sur site de l'antenne (i représentant l'indice de colonne) dans la configuration particulière où la colonne i est mise volontairement en panne. L'indice 0 correspond au cas où aucune colonne n'est en panne.

La nécessité d'utiliser le triplet ($\Sigma$, $\Delta$, $\Omega$) du diagrammes de rayonnement se justifie par le fait qu'un seul diagramme ne suffit pas à la localisation précise d'une colonne en panne. En effet, l'énergie appliquée à l'entrée de la voie ($\Sigma$) de l'antenne se répartit entre les trente cinq colonnes avant avec la même phase et des amplitudes décroissantes du centre de l'antenne vers les extrémités. Ainsi, le diagramme ($\Sigma$) ne permet de détecter que les pannes des colonnes proches du centre de l'antenne, avec de plus une ambiguïté sur la position relative de ces colonnes par rapport à ce centre. Pour le diagramme de rayonnement ($\Delta$), les dix sept colonnes situées à gauche de la colonne centrale sont alimentées en opposition de phase par rapport aux dix sept colonnes situées à droite. Ceci permet de lever l'ambiguïté précédente. De plus, la répartition en amplitude du diagramme $\Delta$ permet de traiter plus spécifiquement les colonnes placées de part et d'autre du centre de chaque moitié de l'antenne. Enfin, le diagramme ($\Omega$), pour lequel seule la colonne centrale arrière est alimentée en opposition de phase par rapport aux trente cinq autres colonnes, permet de détecter la panne de cette colonne arrière.

La deuxième étape du procédé selon l'invention, référencée 22, consiste à mesurer sur site à des temps prédéterminés les trois diagrammes de rayonnement $\Sigma$, $\Omega$, $\Delta$ de l'antenne lors de son fonctionnement en interrogation IFF.

La troisième étape notée 44 est le calcul du coefficient de corrélation pour chaque couple de signaux ($\Sigma_i$, $\Sigma$), ($\Delta_i$, $\Delta$), ($\Omega_i$, $\Omega$), sachant que ce coefficient de corrélation pour un couple de signaux ($x_i(t)$, ($x(t)$) est donné par la relation :

$$\rho_{x_i} = \frac{\overline{x_i(t)\,x(t)}}{\sqrt{\overline{x_i^2(t)}\cdot\overline{x^2(t)}}}$$

Ce coefficient $\rho_{x_i}$ permet d'évaluer la ressemblance des deux signaux $x(t)$ et $x_i(t)$, sachant que le maximum de ressemblance est atteint théoriquement pour $\rho_{x_i} = 1$, et la décorrélation totale pour $\rho_{x_i} = 0$.

Les étapes 44 et 55 permettent ainsi la détection de la colonne i en panne. Plus précisément, l'étape 44 permet de calculer les valeurs maxima des coefficients $\rho_{\Sigma_i}$, $\rho_{\Delta_i}$ et $\rho_{\Omega_i}$ ; ces valeurs n'étant pas forcément 1 en pratique car la ressemblance n'est jamais parfaite. La colonne i identifiée comme probablement en panne par l'étape 55 correspond au coefficient de corrélation le plus élevé. Dans le cas où plusieurs colonnes sont en panne, on réitère l'opération à partir de l'étape 33 afin d'examiner l'ensemble des colonnes. Au lieu de procéder par itération, on pourrait tout aussi bien concevoir une bibliothèque plus importante que la précédente, contenant des configurations de panne sur plus d'une colonne.

L'invention propose également un dispositif de mise en oeuvre du procédé tel que décrit précédemment.

Les étapes 11 et 22 du procédé sont des relevés de diagrammes de rayonnement sur site. On utilise pour se faire une balise au sol placée dans la portée optique du radar (typiquement entre 1 km et 50 km), cette balise fonctionnant comme un transpondeur d'avions, à ceci près qu'elle répond à toutes les interrogations émises par l'antenne. Le relevé des trois diagrammes (Σ), (Δ) et (Ω) se fait par mesure des amplitudes crêtes des trois impulsions constituant la réponse de la balise. Ce relevé se fait sur plusieurs tours d'antenne, ce qui permet d'obtenir des diagrammes de rayonnement très précis. L'idée repose sur le fait que la position de l'antenne est généralement connue grâce à un codeur optique par exemple, comportant n bits, et dont la résolution est de $\frac{360°}{2^n}$.

On peut obtenir des diagrammes de rayonnement très précis en relevant les amplitudes crêtes des réponses de la balise pour une position de l'antenne variant de 0° à 360° par un pas qui se rapproche le plus possible de la résolution du codeur. L'obtention de tous les points nécessite de faire les mesures sur plusieurs tours d'antenne. Cependant, il ne s'agit pas d'une contrainte car l'antenne continue d'assurer sa fonction d'interrogateur IFF.

Ce dispositif permet ainsi de mesurer très précisément d'une part, les triplets ($\Sigma_i$, $\Delta_i$, $\Omega_i$) qu'il faut par suite mémoriser dans une bibliothèque, et d'autre part, le triplet (Σ, Δ, Ω) dans le but de détecter une ou plusieurs pannes éventuelles. Le reste du dispositif de test peut être réalisé par tous moyens permettant de calculer les trois coefficients de corrélation $\rho_{\Sigma_i}$, $\rho_{\Delta_i}$ et $\rho_{\Omega_i}$, de rechercher leur maximum, et de déterminer ainsi la colonne probablement en panne.

Comme nous l'avons déjà fait remarquer précédemment, l'invention ne se limite absolument pas aux antennes de radars secondaires de type monopulse et peut s'étendre à tous les cas d'antennes possédant au moins deux sources rayonnantes.

De plus, la constitution de la bibliothèque peut se faire également par simple calcul mathématique.

## Revendications

1. Procédé de test sur site d'une antenne comportant une pluralité de sources rayonnantes, caractérisé en ce qu'il consiste à :
   - constituer une bibliothèque de diagrammes de rayonnement de l'antenne d'une part, lorsque toutes les sources rayonnantes fonctionnent normalement et d'autre part, lorsqu'au moins l'une desdites sources est mise volontairement en panne (11) ;
   - relever le diagramme de rayonnement de l'antenne lors de son fonctionnement sur site (22) ;
   - calculer le coefficient de corrélation dudit diagramme de rayonnement avec chacun des diagrammes de rayonnement contenus dans ladite bibliothèque (33) ;
   - calculer la valeur maximale du coefficient de corrélation (44), de façon à détecter une panne éventuelle d'une ou de plusieurs desdites sources rayonnantes (55).

2. Procédé de test selon la revendication 1, caractérisé en ce que la bibliothèque comporte les diagrammes de rayonnement de l'antenne lorsque chacune des sources rayonnantes est mise en panne à tour de rôle.

3. Procédé de test selon l'une quelconque des revendications précédentes, caractérisé en ce que les diagrammes de rayonnement contenus dans ladite bibliothèque sont relevés sur site.

4. Procédé de test selon l'une quelconque des revendications précédentes, caractérisé en ce que ladite antenne est une antenne de radar secondaire de type monopulse, et en ce que son fonctionnement est représenté par un triplet de diagrammes de rayonnement.

5. Procédé de test selon la revendication 4, caractérisé en ce que ledit triplet est constitué d'un diagramme somme (Σ), d'un diagramme différence (Δ) et d'un diagramme quasi ommidirectionnel (Ω).

6. Procédé de test selon l'une quelconque des revendications 4 et 5, caractérisé en ce que le calcul du coefficient de corrélation est fait pour chaque diagramme de rayonnement constituant ledit triplet.

7. Dispositif de test sur site d'une antenne constituée d'une pluralité de sources rayonnantes, caractérisé en ce qu'il comporte :
   - des premiers moyens de mesures et de mémorisation dans une bibliothèque des diagrammes de rayonnement de l'antenne d'une part, lorsque toutes les sources rayonnantes fonctionnent, et d'autre part, lorsqu'au moins l'une desdites sources est mise volontairement en panne ;
   - des seconds moyens de mesure du diagramme de rayonnement de l'antenne lors de son fonctionnement sur site ;
   - des moyens de calcul du coefficient de corrélation du diagramme de rayonnement de l'antenne et de chaque diagramme contenu dans ladite bibliothèque ;
   - des moyens de calcul de la valeur maximale du coefficient de corrélation pour détecter une panne éventuelle.

8. Dispositif de test selon la revendication 7, caractérisé en ce que lesdits premiers moyens effectuent les mesures des diagrammes de rayonnement sur site.

9. Dispositif de test selon l'une quelconque des revendications 7 ou 8, caractérisé en ce que ladite antenne est une antenne de radar secondaire de type monopulse et en ce que lesdits moyens de mesure sur site des diagrammes de rayonnement sont constitués d'une balise au sol placée dans la portée optique du radar, et répondant à toutes les interrogations de l'antenne et de moyens pour mesurer l'amplitude crête des réponses de ladite balise sur plusieurs tours d'antenne.

**Patentansprüche**

1. Verfahren zum Testen einer Antenne mit mehreren Strahlungsquellen am Einsatzort, dadurch gekennzeichnet, daß es darin besteht, daß:
   - eine Bibliothek aus Strahlungsdiagrammen der Antenne gebildet wird, einerseits für den Fall, daß alle Strahlungsquellen normal arbeiten, und andererseits für den Fall, daß wenigstens eine der Quellen absichtlich in einen Fehlerzustand versetzt ist (11);
   - das Strahlungsdiagramm der Antenne bei ihrem Betrieb am Einsatzort erfaßt wird (22);
   - der Korrelationskoeffizient des Strahlungsdiagramms mit jedem der in der Bibliothek enthaltenen Diagramme berechnet wird (33);
   - der maximale Wert des Korrelationskoeffizienten in der Weise berechnet wird (44), daß ein möglicher Ausfall einer oder mehrerer der Strahlungsquellen festgestellt wird (55).

2. Testverfahren nach Anspruch 1, dadurch gekennzeichnet, daß die Bibliothek Strahlungsdiagramme der Antenne für die Fälle enthält, daß jede der Strahlungsquellen der Reihe nach in einen Fehlerzustand versetzt ist.

3. Testverfahren nach einem der vorhergehenden Ansprüche, dadurch gekennzeichnet, daß die Strahlungsdiagramme, die in der Bibliothek enthalten sind, hinsichtlich des Höhenwinkels erfaßt werden.

4. Testverfahren nach einem der vorhergehenden Ansprüche, dadurch gekennzeichnet, daß die Antenne eine Antenne für ein Monopuls-Sekundär-Radargerät ist und daß ihr Betrieb durch eine Dreiergruppe von Strahlungsdiagrammen repräsentiert wird.

5. Testverfahren nach Anspruch 4, dadurch gekennzeichnet, daß die Dreiergruppe aus einem Summendiagramm ($\Sigma$), einem Differenzdiagramm ($\Delta$) und einem Quasi-Rundstrahldiagramm ($\Omega$) besteht.

6. Testverfahren nach einem der Ansprüche 4 und 5, dadurch gekennzeichnet, daß die Berechnung des Korrelationskoeffizienten für jedes die Dreiergruppe bildende Strahlungsdiagramm durchgeführt wird.

7. Vorrichtung zum Testen einer aus mehreren Strahlungsquellen gebildeten Antenne am Einsatzort, dadurch gekennzeichnet, daß sie enthält:
   - erste Mittel zum Messen und Speichern von Strahlungsdiagrammen der Antenne, einerseits für den Fall, daß alle Strahlungsquellen arbeiten, und andererseits für den Fall, daß wenigstens eine der Quellen absichtlich in einen Fehlerzustand versetzt ist;
   - zweite Mittel zum Messen des Strahlungsdiagramms der Antenne, wenn diese an ihrem Einsatzort arbeitet;
   - Mittel zum Berechnen des Korrelationskoeffizienten des Strahlungsdiagramms der Antenne und jedes in der Bibliothek enthaltenen Diagramms;
   - Mittel zum Berechnen des Maximalwerts des Korrelationskoeffizienten zum Feststellen eines möglichen Fehlerzustandes.

8. Testvorrichtung nach Anspruch 7, dadurch gekennzeichnet, daß die ersten Mittel die Strahlungsdiagrammessungen am Einsatzort bewirken.

9. Testvorrichtung nach einem der Ansprüche 7 oder 8, dadurch gekennzeichnet, daß die Antenne eine Antenne eines Monopuls-Sekundär-Radargeräts ist und daß die Mittel zum Messen der Strahlungsdiagramme am Einsatzort von einer Boden-Funkbake, die innerhalb der optischen Reichweite des Radar-Geräts angeordnet ist und auf alle Abfragen der Antenne antwortet, sowie von Mitteln zum Messen der Spitzenamplitude der Antworten der Funkbake über mehrere Antennenumdrehungen gebildet sind.

**Claims**

1. Method for on-site test of an antenna including a plurality of radiating sources, characterized in that it consists in:
   - compiling a library of radiation patterns of the antenna on the one hand, when all the radiating sources are operating normally and, on the other hand, when at least one of the said sources is deliberately made unserviceable (11);
- plotting the radiation pattern of the antenna when it is operating on site (22);
- calculating the coefficient of correlation of the said radiation pattern with each of the radiation patterns contained in the said library (33);
- calculating the maximum value of the coefficient of correlation (44), so as to detect a possible failure of one or more of the said radiating sources (55).

2. Test method according to Claim 1, characterized in that the library includes the radiation patterns of the antenna when each of the radiating sources is made unserviceable in turn.

3. Test method according to one of the preceding claims, characterized in that the radiation patterns contained in the said library are plotted on site.

4. Test method according to any one of the preceding claims, characterized in that the said antenna is a monopulse-type secondary radar antenna, and in that its operation is represented by a triplet of radiation patterns.

5. Test method according to Claim 4, characterized in that the said triplet consists of a sum ($\Sigma$) pattern, of a difference ($\Delta$) pattern and of a quasi-omnidirectional ($\Omega$) pattern.

6. Test method according to any one of Claims 4 and 5, characterized in that the calculation of the coefficient of the correlation is done for each radiation pattern constituting the said triplet.

7. Device for on-site test of an antenna consisting of a plurality of radiating sources, characterized in that it includes:
- first means for measurement and memory storage in a library of the radiation patterns of the antenna on the one hand, when all the radiating sources are operating, and, on the other hand, when at least one of the said sources is deliberately made unserviceable;
- second means for measuring the radiation pattern of the antenna when it is operating on site;
- means of calculating the coefficient of correlation of the radiation pattern of the antenna and of each pattern contained in the said library;
- means of calculating the maximum value of the coefficient of correlation in order to detect a possible failure.

8. Test device according to Claim 7, characterized in that the said first means perform the radiation pattern measurements on site.

9. Test device according to any one of Claims 7 or 8, characterized in that the said antenna is a monopulse-type secondary radar antenna and in that the said means for on-site measurement of the radiation patterns consist of a ground beacon placed within the optical range of the radar, and responding to all the interrogations from the antenna, and of means for measuring the peak amplitude of the responses from the said beacon over several antenna revolutions.

FIG.1

FIG.2

# FIG.3

FIG.4

Pour i = 0,.., 36

Mesure de $\Sigma_i$

$\Omega_i$

$\Delta_i$

— 11

Mesure de $\Sigma$

$\Omega$

$\Delta$

— 22

Pour i = 0,.., 36

$$\rho_{\Sigma_i} = \frac{\overline{\Sigma_i \quad \Sigma}}{\sqrt{\overline{\Sigma_i^2} \quad \overline{\Sigma^2}}}$$

$$\rho_{\Delta_i} = \frac{\overline{\Delta_i \quad \Delta}}{\sqrt{\overline{\Delta_i^2} \quad \overline{\Delta^2}}}$$

$$\rho_{\Omega_i} = \frac{\overline{\Omega_i \quad \Omega}}{\sqrt{\overline{\Omega_i^2} \quad \overline{\Omega^2}}}$$

— 33

$\max (\rho_{\Sigma_i})$

$\max (\rho_{\Delta_i})$

$\max (\rho_{\Omega_i})$

— 44

DETECTION
DE
PANNE

— 55